# EUROPEAN PATENT APPLICATION

(11) **EP 1 655 814 A2**
(43) Date of publication of application: **10.05.2006**
(21) Application number: 05255778.2
(22) Date of filing: 19.09.2005
(51) Int. Cl.: H01S 5/40

(54) **Multiple-wavelength laser diode and method of fabricating the same**

(30) Priority: 03.11.2004 KR 2004088913
(71) Applicant: Samsung Electro-mechanics Co., Ltd, Suwon-si, Gyeonggi-do (KR)
(72) Inventor: Ryu, Han-youl, 4-6 Gyeonghui Univille, Suwon-si Gyeonggi-do (KR); Ha, Kyoung-ho, Seoul (KR); Nam, Ok-hyun, 106-504 Pureun Maeul Apt., Seoul (KR)
(74) Representative: Greene, Simon Kenneth

(57) **Abstract**

Provided are a multiple-wavelength laser diode (LD) and method of fabricating the same. The multiple-wavelength LD includes at least three LDs, which are sequentially stacked and aligned such that centers of emission points of the three LDs form a line.

## Description

The present invention relates to a multiple-wavelength laser diode (LD) and method of fabricating the same, and more particularly, to a multiple-wavelength LD, which inhibits aberration and has high condensing efficiency, and method of fabricating the same.

A compound semiconductor light emitting device, such as a light emitting diode (LED) or a semiconductor LD, converts an electric signal into light using the properties of a compound semiconductor and produces laser beams, which have been put to practical use in the fields of optical communications, multiple communications, and space communications. In particular, the semiconductor LD is being widely used as a light source for a data transmission unit or a data writing/reading unit in the field of communications, such as optical communications, or in apparatuses, such as compact disk players (CDPs) or digital versatile disk players (DVDPs).

In recent years, a blue-ray disk (BD) has been developed as the next-generation storage medium to take the place of a conventional compact disk (CD) or digital versatile disk (DVD), and there is a strong likelihood that the demand for the BD will greatly increase. An optical pickup for a BD is preferably compatible with the conventional CD or DVD such that the CD or DVD can reproduce or write data using the optical pickup for the BD. Specifically, an LD for a BD, an LD for a DVD, and an LD for a CD produce laser beams with different wavelengths, for example, bluish-purple, red, and infrared wavelengths. When optical pickups are separately prepared for the respective LDs, the entire optical pickup system becomes large-sized and the cost of production increases. Therefore, it is desirable to embody a common optical pickup system to all the LDs for the BD, DVD, and CD. For the common optical pickup system, the three kinds of LDs should be integrally formed as a single package. In this case, to simplify the design of the optical pickup system, the three LDs should be arrayed as close to each other as possible. Although a conventional technique proposes a structure.in which LDs for a BD, a DVD, and a CD are integrally formed as a single package, a distance between two adjacent ones of the LDs is very large. This conventional structure exhibits low condensing efficiency and causes much aberration. Also, the conventional technique leads the entire optical pickup system to increase in size and need a complicated design.

The present invention provides a multiple-wavelength laser diode (LD), which inhibits aberration and exhibits high condensing efficiency, and method of fabricating the same.

According to an aspect of the present invention, there is provided a multiple-wavelength LD, which includes at least a first LD, a second LD, and a third LD that are sequentially stacked and aligned such that centers of emission points of the first, second, and third LDs form a line. In this multiple-wavelength LD, a distance between two adjacent centers of the emission points of the first, second, and third LDs may be within the range of about 100 µm.

The first LD, which underlies the second and third diodes, includes a first laser oscillation layer including a first resonant layer and a first n-type compound semiconductor layer and a first p-type compound semiconductor layer prepared on both surfaces of the first resonant layer, respectively; a first n-type electrode layer and a first p-type electrode layer prepared on both surfaces of the first laser oscillation layer, respectively; and a bonding metal layer prepared on one surface of at least one of the first n-type electrode layer and the first p-type electrode layer.

The first n-type compound semiconductor layer may include a GaN substrate; a first buffer layer disposed on the GaN substrate and formed of GaN; and a first n-type clad layer disposed on the first buffer layer and formed of AlGaN. The first resonant layer may include a first active layer formed of InGaN; and first waveguide layers disposed on and under the first active layer, respectively, and formed of InGaN. Also, the first p-type compound semiconductor layer may include a first p-type clad layer disposed on the first resonant layer and formed of AlGaN; and a first p-type contact layer disposed on the first p-type clad layer and formed of GaN.

The second LD may include a second laser oscillation layer including a second resonant layer and a second n-type compound semiconductor layer and a second p-type compound semiconductor layer prepared on both surfaces of the second resonant layer, respectively; a second n-type electrode layer and a second p-type electrode layer prepared on both surfaces of the second laser oscillation layer, respectively; and a bonding metal layer prepared on one surface of at least one of the second n-type electrode layer and the second p-type electrode layer.

The second p-type compound semiconductor layer may include a second p-type contact layer disposed on the second p-type electrode layer and formed of GaAs; and a second p-type clad layer disposed on the second p-type contact layer and formed of AlGalnP. The second resonant layer may include a second active layer formed of AlGalnP; and second waveguide layers disposed on and under the second active layer, respectively, and formed of AlGalnP. Also, the second n-type compound semiconductor layer may include a second n-type clad layer disposed on the second resonant layer and formed of AlGalnP; and a second n-type contact layer disposed on the second n-type clad layer and formed of AlGalnP.

The third LD may include a third laser oscillation layer including a third resonant layer and a third n-type compound semiconductor layer and a third p-type compound semiconductor layer prepared on both surfaces of the third resonant layer, respectively; a third n-type electrode layer and a third p-type electrode layer prepared on both surfaces of the third laser oscillation layer, respectively; and a bonding metal layer prepared on one surface of at least one of the third n-type electrode layer and the third p-type electrode layer.

The third p-type compound semiconductor layer may include a third p-type contact layer disposed on the third p-type electrode layer and formed of GaAs; and a third p-type clad layer disposed on the third p-type contact layer and formed of AlGaAs. The third resonant layer may include a third active layer formed of AlGaAs; and third waveguide layers disposed on and under the third active layer, respectively, and formed of AlGaAs. Also, the third n-type compound semiconductor layer may include a third n-type clad layer disposed on the third resonant layer and formed of AlGaAs; a third buffer layer disposed on the third n-type clad layer and formed of GaAs; and a GaAs substrate stacked on the third buffer layer.

According to another aspect of the present invention, there is provided a method of fabricating a multiple-wavelength LD. The method includes preparing at least a first LD, a second LD, and a third LD, each having a first surface and a second surface that face each other; bonding a second surface of the second LD to a second surface of the first LD; sequentially forming an electrode layer and a bonding metal layer on a first surface of the second LD; and bonding a second surface of the third LD to the bonding metal layer of the second LD. In this method, the first, second, and third LDs are sequentially stacked and aligned such that centers of emission points of the first, second, and third LDs form a line. Also, a distance between two adjacent centers of the emission points of the first, second, and third LDs may be within the range of about 100 µm. The second LDs may further include a substrate disposed on the first surface thereof. In this case, the method may further include removing the substrate of the second LD after bonding the second surface of the second LD to the second surface of the first LD and before sequentially forming the electrode layer and the bonding metal layer on the first surface of the second LD.

The first LD may include a first laser oscillation layer including a first resonant layer and a first n-type compound semiconductor layer and a first p-type compound semiconductor layer prepared on both surfaces of the first resonant layer, respectively; a first n-type electrode layer and a second p-type electrode layer prepared on both surfaces of the first laser oscillation layer, respectively; and a bonding metal layer prepared on one surface of at least one of the first n-type electrode layer and the first p-type electrode layer.

The first n-type compound semiconductor layer may include a GaN substrate; a first buffer layer disposed on the GaN substrate and formed of GaN; and a first n-type clad layer disposed on the first buffer layer and formed of AlGaN. The first resonant layer may include a first active layer formed of InGaN; and first waveguide layers disposed on and under the first active layer, respectively, and formed of InGaN. Also, the first p-type compound semiconductor layer may include a first p-type clad layer disposed on the first resonant layer and formed of AlGaN; and a first p-type contact layer disposed on the first p-type clad layer and formed of GaN.

The second LD may include a second laser oscillation layer including a second resonant layer and a second n-type compound semiconductor layer and a second p-type compound semiconductor layer prepared on both surfaces of the second resonant layer, respectively; an electrode layer prepared on a second surface of the second laser oscillation layer; and a bonding metal layer prepared on the electrode layer.

The second n-type compound semiconductor layer may include a GaAs substrate; a second buffer layer disposed on the GaAs substrate and formed of GaAs; a second n-type contact layer disposed on the second buffer layer and formed of AlGalnP; and a second n-type clad layer disposed on the second n-type contact layer and formed of AlGalnP. The second resonant layer may include a second active layer formed of AlGalnP; and second waveguide layers disposed on and under the second active layer, respectively, and formed of AlGalnP. Also, the second p-type compound semiconductor layer may include a second p-type clad layer disposed on the second resonant layer and formed of AlGaInP; and a second p-type contact layer disposed on the second p-type clad layer and formed of GaAs. In this case, the method may further include removing the GaAs substrate and the second buffer layer after bonding the second surface of the second LD to the second surface of the first LD and before sequentially forming the electrode layer and the bonding metal layer on the first surface of the second LD.

The third LD may include a third laser oscillation layer including a third resonant layer and a third n-type compound semiconductor layer and a third p-type compound semiconductor layer prepared on both surfaces of the third resonant layer, respectively; a third n-type electrode layer and a third p-type electrode layer prepared on both surfaces of the third laser oscillation layer, respectively; and a bonding metal layer prepared on one surface of at least one of the third n-type electrode layer and the third p-type electrode layer.

The third n-type compound semiconductor layer may include a GaAs substrate; a third buffer layer disposed on the GaAs substrate and formed of GaAs; and a third n-type clad layer disposed on the third buffer layer and formed of AlGaAs. The third resonant layer may include a third active layer formed of AlGaAs; and third waveguide layers disposed on and under the third active layer, respectively, and formed of AlGaAs. The third p-type compound semiconductor layer may include a third p-type clad layer disposed on the third resonant layer and formed of AlGaAs; and a third p-type contact layer disposed on the third p-type clad layer and formed of GaAs.

The above and other features and advantages of the present invention will become more apparent by describing in detail exemplary embodiments thereof with reference to the attached drawings in which:
FIG. 1 is a cross sectional view of a multiple-wavelength laser diode (LD) according to an exemplary embodiment of the present invention;
FIG. 2 is an exploded view of a first LD shown in FIG. 1;
FIG. 3 is an exploded view of a second LD shown in FIG. 1;
FIG. 4 is an exploded view of a third LD shown in FIG. 1; and
FIGS. 5A through 5H are cross sectional views illustrating a method of fabricating the multiple-wavelength LD shown in FIG. 1.

A multiple-wavelength laser diode (LD) and method of fabricating the same will now be described more fully hereinafter with reference to the accompanying drawings, in which exemplary embodiments of the invention are shown.

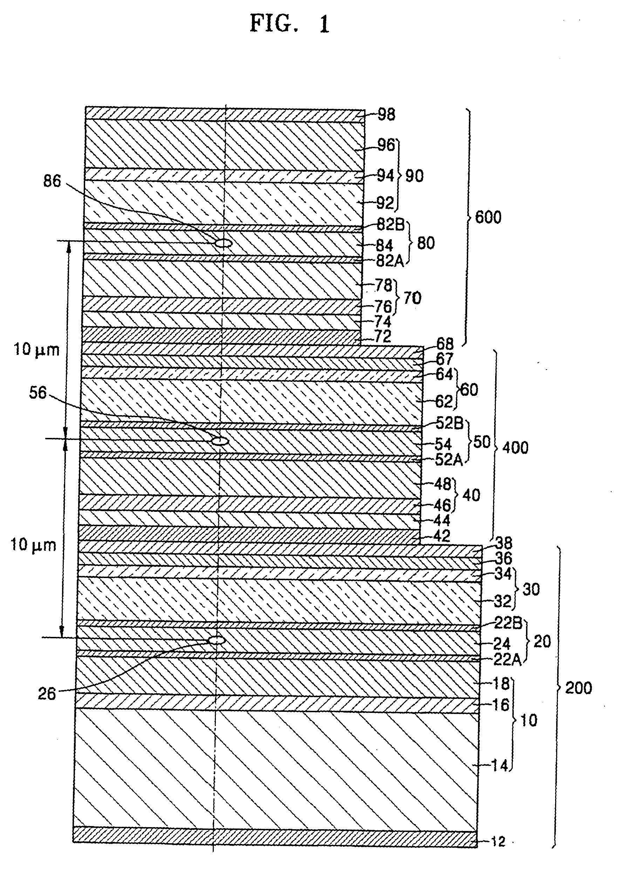

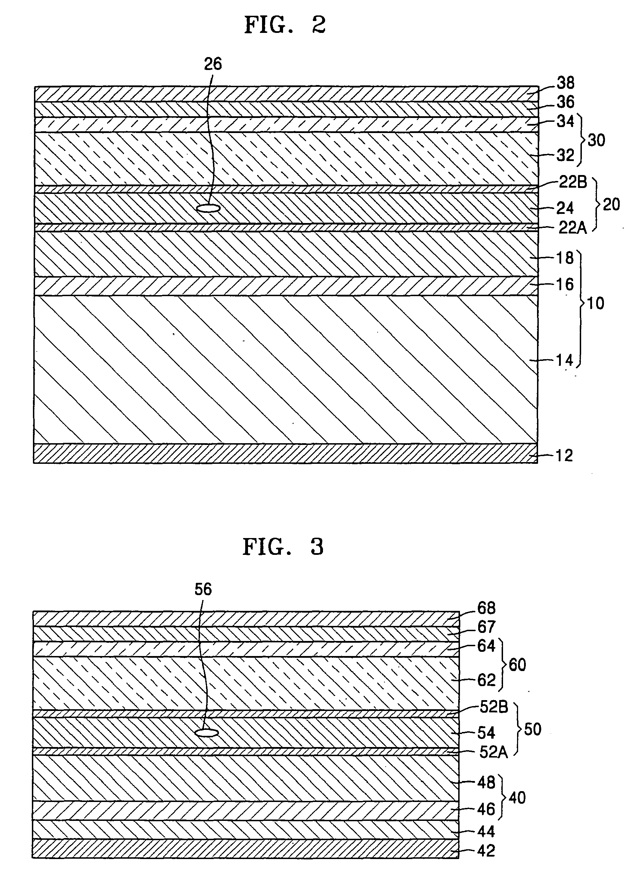

FIG. 1 is a cross sectional view of a multiple-wavelength LD according to an exemplary embodiment of the present invention, and FIGS. 2, 3, and 4 are exploded views of first, second, and third LDs shown in FIG. 1, respectively.

Referring to FIG. 1, a first LD 200, a second LD 400, and a third LD 600 are sequentially stacked, and two adjacent LDs are bonded to each other. Also, the first, second, and third LDs 200, 400, and 600 are aligned such that centers of first, second, and third emission points 26, 56, and 86 form a line, and a distance between two adjacent centers of the emission points 26, 56, and 86 is within the range of about 100 µm, more preferably, 10 µm.

In an alternative embodiment, a distance between two adjacent centers of the emission points 26, 56, and 86 is less than 150 µm. Further, in a particularly preferred embodiment, it is approximately 10 µm or less.

A hit sink (not shown) may be further disposed in a lower portion of the first LD 200. The hit sink enables the efficient radiation of heat generated from the first, second, and third LDs 200, 400, and 600.

The multiple-wavelength LD having the above-described structure can be applied to an optical system that requires a plurality of light sources. In particular, since a distance between two adjacent centers of the emission points 26, 56, and 86 can be reduced to several µm or less, a plurality of laser beams of light are easily condensed using a single optical lens, aberration is inhibited, and condensing efficiency is enhanced. Also, the entire optical pickup system is downscaled and simply designed.

Referring to FIGS. 1 and 2, the first LD 200 includes a first n-type compound semiconductor layer 10, a first resonant layer 20, a first p-type compound semiconductor layer 30, a first p-type electrode layer 36, and a bonding metal layer 38, which are sequentially formed. Also, a first n-type electrode layer 12 is formed on a bottom surface of the first n-type compound semiconductor layer 10 to correspond to the first p-type electrode layer 36.

The first n-type compound semiconductor layer 10 includes a GaN substrate 14, a first buffer layer 16, and a first n-type clad layer 18. The first buffer layer 16 is formed on the GaN substrate 14 using GaN, and the first n-type clad layer 18 is formed on the first buffer layer 16 using AlGaN. Also, the first resonant layer 20 includes a first active layer 24 and first waveguide layers 22a and 22b formed under and on the first active layer 24, respectively. The first active layer 24 is formed of InGaN, and the first waveguide layers 22a and 22b also are formed of InGaN. Further, the first p-type compound semiconductor layer 30 includes a first p-type clad layer 32 and a first p-type contact layer 34. The first p-type clad layer 32 is formed on the first resonant layer 20 using AIGaN, and the first p-type contact layer 34 is formed on the first p-type clad layer 32 using GaN. Also, the first emission point 26 is disposed in the first active layer 24 and emits a first laser beam.

Referring to FIGS. 1 and 3, the second LD 400 includes a bonding metal layer 42, a second p-type electrode layer 44, a second p-type compound semiconductor layer 40, a second resonant layer 50, a second n-type compound semiconductor layer 60, a second n-type electrode layer 67, and a bonding metal layer 68, which are sequentially formed.

The second p-type compound semiconductor layer 40 includes a second p-type contact layer 46 and a second p-type clad layer 48. The second p-type contact layer 46 is formed on the second p-type electrode layer 44 using GaAs, and the second p-type clad layer 48 is formed on the second p-type contact layer 46 using AlGaInP. Also, the second resonant layer 50 includes a second active layer 54 and second waveguide layers 52a and 52b formed under and on the second active layer 54, respectively. The second active layer 54 is formed of AlGaInP, and the second waveguide layers 52a and 52b also are formed of AlGaInP. Further, the second n-type compound semiconductor layer 60 includes a second n-type clad layer 62 and a second n-type contact layer 64. The second n-type clad layer 62 is formed on the second resonant layer 50 using AlGalnP, and the second n-type contact layer 64 is formed on the second n-type clad layer 62 using AlGalnP. Also, the second emission point 56 is disposed in the second active layer 54 and emits a second laser beam.

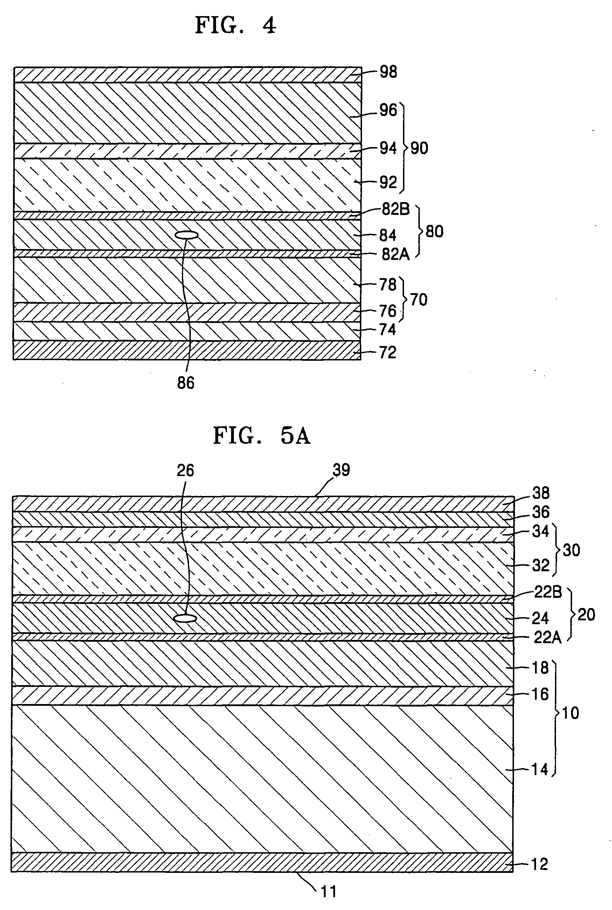

Referring to FIGS. 1 and 4, the third LD 600 includes a bonding metal layer 72, a third p-type electrode layer 74, a third p-type compound semiconductor layer 70, a third resonant layer 80, a third n-type compound semiconductor layer 90, and a third n-type electrode layer 98, which are sequentially stacked.

The third p-type compound semiconductor layer 70 includes a third p-type contact layer 76 and a third p-type clad layer 78. The third p-type contact layer 76 is formed on the third p-type electrode layer 74 using GaAs, and the third p-type clad layer 78 is formed on the third p-type contact layer 76 using AlGaAs. Also, the third resonant layer 80 includes a third active layer 84 and third waveguide layers 82a and 82b formed under and on the third active layer 84. The third active layer 84 is formed of AlGaAs, and the third waveguide layers 82a and 82b also are formed of AlGaAs. Further, the third n-type compound semiconductor layer 90 includes a third n-type clad layer 92, a third buffer layer 94, and a GaAs substrate 96. The third n-type clad layer 92 is formed on the third resonant layer 80 using AlGaAs, the third buffer layer 94 is formed on the third n-type clad layer 92 using GaAs, and the GaAs substrate is stacked on the third buffer layer 94. Also, the third emission point 86 is disposed in the third active layer 84 and emits a third laser beam.

FIGS. 5A through 5H are cross sectional views illustrating a method of fabricating the multiple-wavelength LD shown in FIG. 1.

At the outset, as shown in FIGS. 5A through 5C, at least three LDs, for example, a first LD, a second LD, and a third LD, each of which has a first surface and a second surface that face each other, are prepared.

Referring to FIG. 5A, the first LD is the same as the first LD shown in FIG. 2. Thus, a description of the same elements as in the first LD shown in FIG. 2 will be omitted here, and the same reference numerals are used to denote the same elements. The first LD includes a bottom surface of a stack structure (e.g., a first surface 11 that corresponds to an outer surface of a first n-type electrode 12) and a top surface of the stacked structure (e.g., a second surface 39 that corresponds to an outer surface of a bonding metal layer 38, and the first and second surfaces 11 and 39 face each other.

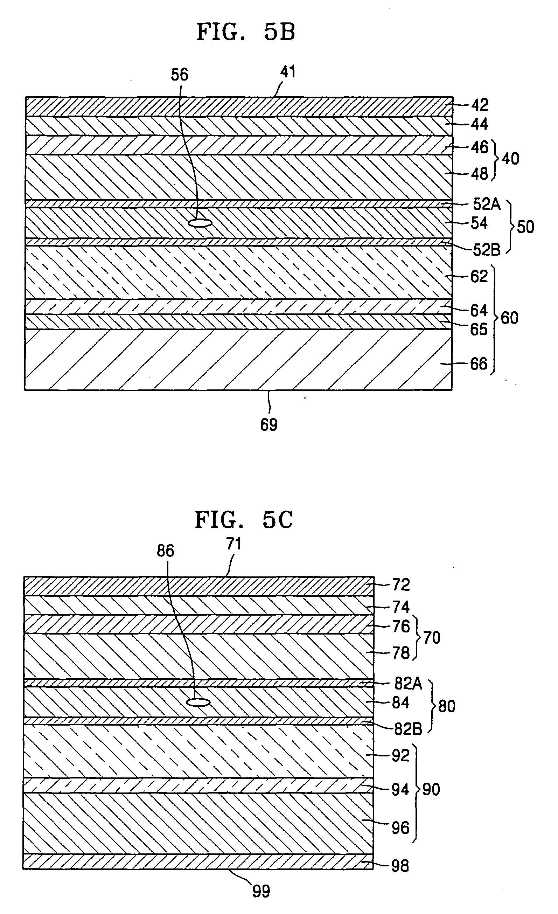

Referring to FIG. 5B, the second LD is almost the same as the second LD shown in FIG. 3. Thus, a description of the same elements as in the second LD shown in FIG. 3 will be omitted here, and the same reference numerals are used to denote the same elements.

The second LD includes a second n-type compound semiconductor layer 60, a second resonant layer 50, a second p-type compound semiconductor layer 40, a second p-type electrode layer 44, and a bonding metal layer 42.

The second n-type compound semiconductor layer 60 includes a GaAs substrate 66, a second buffer layer 65, a second n-type contact layer 64, and a second n-type clad layer 62. The second buffer layer 65 is formed on the GaAs substrate 66 using GaAs, the second n-type contact layer 64 is formed on the second buffer layer 65 using AlGalnP, and the second n-type clad layer 62 is formed on the second n-type contact layer 64 using AlGalnP. Also, the second resonant layer 50 includes a second active layer 54 and second waveguide layers 52a and 52b disposed on and under the second active layer 54, respectively. The second active layer 54 is formed of AlGaInP, and the second waveguide layers 52a and 52b also are formed of AlGaInP. Further, the second p-type compound semiconductor layer 40 includes a second p-type clad layer 48 and a second p-type contact layer 46. The second p-type clad layer 48 is formed on the second resonant layer 50 using AlGalnP, and the second p-type contact layer 46 is formed on the second p-type clad layer 48 using GaAs. The second LD includes a bottom surface of a stack structure (e.g., a first surface 69 that corresponds to an outer surface of the GaAs substrate 66) and a top surface of the stacked structure (e.g., a second surface 41 that corresponds to an outer surface of a bonding metal layer 42), and the first and second surfaces 69 and 42 face each other.

Referring to FIG. 5C, the third LD is almost the same as the third LD shown in FIG. 4. Thus, a description of the same elements as in the third LD shown in FIG. 4 will be omitted here, and the same reference numerals are used to denote the same elements.

The third LD includes a bottom surface of a stack structure (e.g., a first surface 99 that corresponds to an outer surface of a third n-type electrode layer 98) and a top surface of the stacked structure (e.g., a second surface 71 that corresponds to an outer surface of a bonding metal layer 72), and the first and second surfaces 99 and 71 face each other.

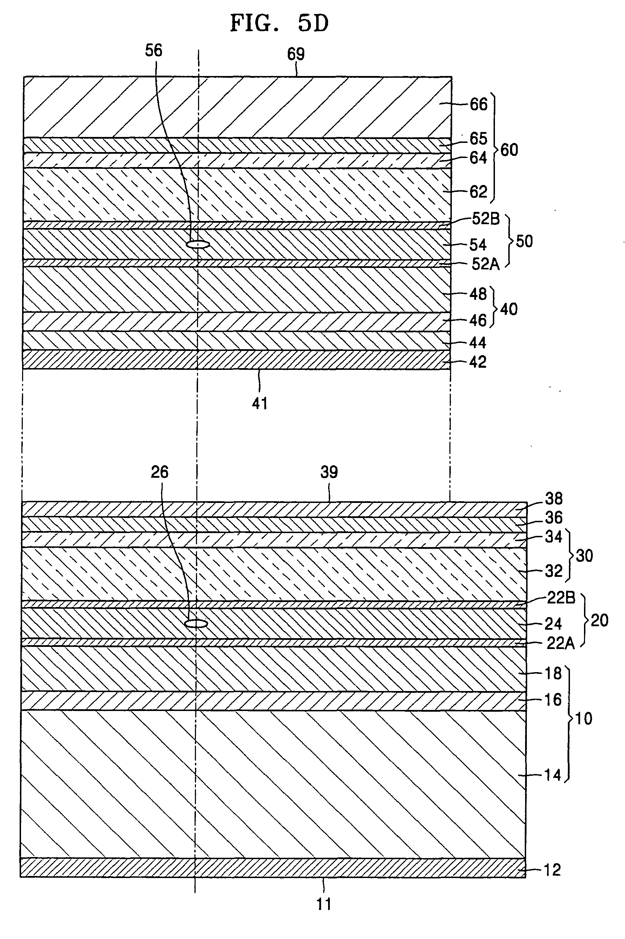

Referring to FIG. 5D, the second surface 41 of the second LD is bonded to the second surface 39 of the first LD so that the second LD is stacked on the first LD. As a result, the bonding metal layer 38 of the first LD is bonded to the bonding metal layer 42 of the second LD. In this case, the second LD is aligned with the first LD such that centers of emission points 26 and 56 form a line.

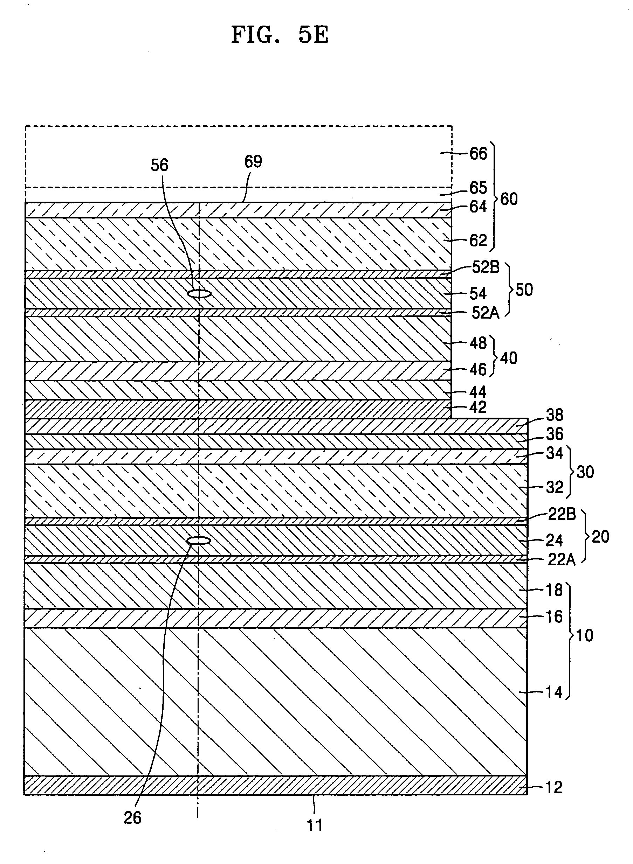

Referring to FIG. 5E, the GaAs substrate 66 and the second buffer layer 65 are removed from the second LD. The removal of the GaAs substrate 66 and the second buffer layer 65 may be performed using a lift-off process, for example, a wet etching process. During the wet etching process, the second n-type contact layer 64 may function as an etching stop layer. Specifically, an etchant for the wet etching process may selectively remove only the GaAs substrate 66 and the second buffer layer 65 but leave the second n-type contact layer 64 intact. Thus, the wet etching process can stop at the second n-type contact layer 64. Alternatively, it is possible to remove even the second n-type contact layer 64 using another etchant during the wet etching process.

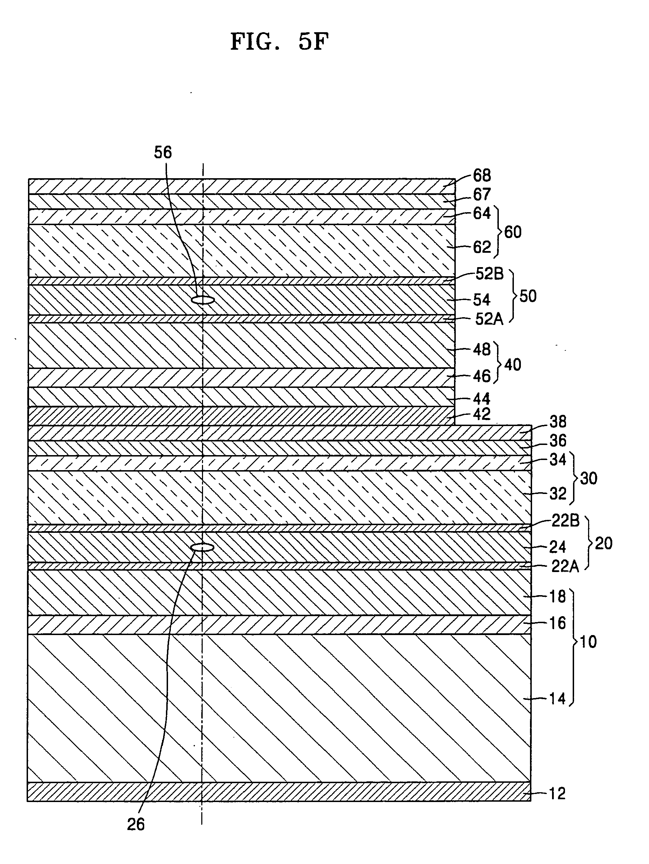

Referring to FIG. 5F, an electrode layer 67 and a bonding metal layer 68 are sequentially stacked on a first surface of the second LD, for example, on the second n-type contact layer 64.

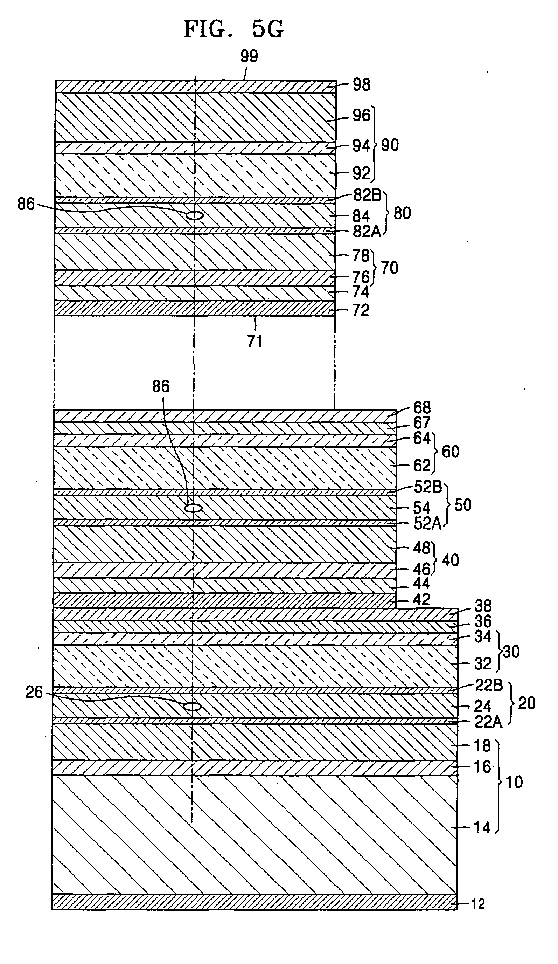

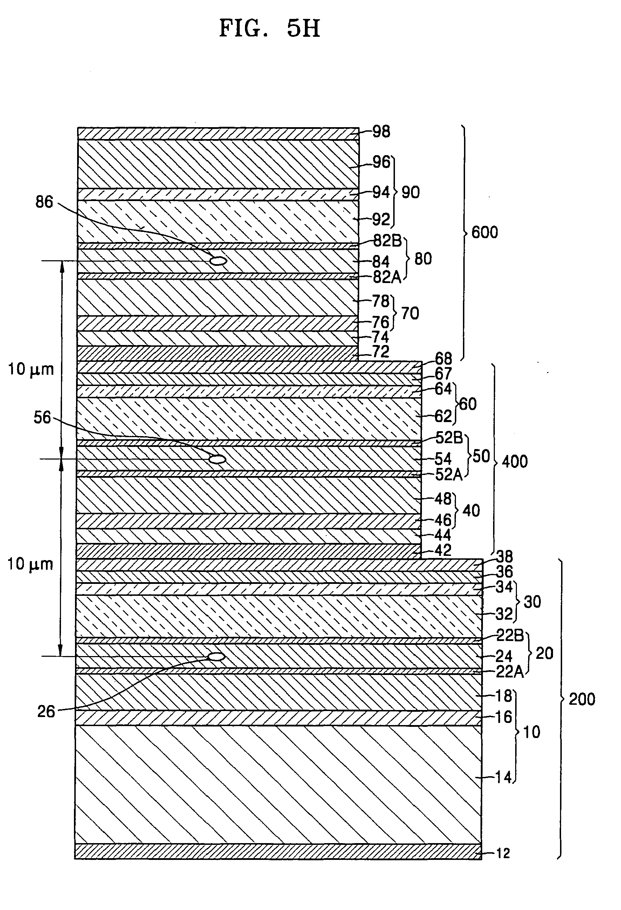

Referring to FIGS. 5G and 5H, the second surface 71 of the third LD is bonded to the bonding metal layer 68 of the second LD so that the third LD is stacked on the second LD. As a result, the bonding metal layer 68 of the second LD is bonded to the bonding metal layer 72 of the third LD. In this case, the third LD is aligned with the first and second LDs such that the centers of the emission points 26, 56, and 86 form a line.

The above-described method simplifies the fabricating process of the multiple-wavelength LD, reduces the cost of production, and increases yield.

According to the present invention, the multiple-wavelength LD includes at least three laser sources, which are aligned with each other, and a distance between two adjacent centers of emission points of the laser sources is within the range of about 100 µm. Therefore, when the multiple-wavelength LD is applied to an optical system that requires a plurality of light sources, the optical system can be structurally simple. Also, according to the present invention, since a distance between two adjacent laser sources is very small, a plurality of laser beams are easily condensed using a single optical lens, aberration is inhibited, and condensing efficiency is enhanced.

Further, the present invention provides a simple method of fabricating the multiple-wavelength LD having the above-described effects. According to this method, a distance between two adjacent centers of emission points is reduced to 10 µm or less, thus enabling the fabrication of a multiple-wavelength LD with little aberration and high condensing efficiency.

The multiple-wavelength LD according to the present invention can be employed as a light source for an optical pickup that serves to write and reproduce data in blue-ray disks (BDs), digital versatile disks (DVDs), or compact disks (CDs).

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A multiple-wavelength laser diode comprising at least a first laser diode (200), a second laser diode (400), and a third laser diode (600) that are sequentially stacked and aligned such that centers of emission points (26, 56, 86) of the first, second, and third laser diodes form a line.

2. The laser diode of claim 1, wherein a distance between two adjacent centers of the emission points (26, 56, 86) of the first, second, and third laser diodes is less than 150 µm.

3. The laser diode of claim 1 or 2, wherein the first laser diode (200), which underlies the second and third diodes (400, 600), comprises:
a first laser oscillation layer including a first resonant layer (20) and a first n-type compound semiconductor layer (10) and a first p-type compound semiconductor layer (30) prepared on both surfaces of the first resonant layer, respectively;
a first n-type electrode layer (12) and a first p-type electrode layer (36) prepared on both surfaces of the first laser oscillation layer, respectively; and
a bonding metal layer (38) prepared on one surface of at least one of the first n-type electrode layer (12) and the first p-type electrode layer (36).

4. The laser diode of claim 3, wherein the first n-type compound semiconductor layer (10) includes:
a GaN substrate (14);
a first buffer layer (16) disposed on the GaN substrate and formed of GaN; and
a first n-type clad layer (18) disposed on the first buffer layer (16) and
formed of AlGaN,
wherein the first resonant layer (20) includes:
a first active layer (24) formed of InGaN; and
first waveguide layers (22a, 22b) disposed on and under the first active layer (24), respectively, and formed of InGaN,
and wherein the first p-type compound semiconductor layer (30) includes:
a first p-type clad layer (32) disposed on the first resonant layer and formed of AlGaN; and
a first p-type contact layer (34) disposed on the first p-type clad layer (32) and formed of GaN.

5. The laser diode of any preceding claim, wherein the second laser diode (400) comprises:
a second laser oscillation layer including a second resonant layer (50) and a second n-type compound semiconductor layer (60) and a second p-type compound semiconductor layer (40) prepared on both surfaces of the second resonant layer (50), respectively;
a second n-type electrode layer (67) and a second p-type electrode layer (44) prepared on both surfaces of the second laser oscillation layer, respectively; and
a bonding metal layer (42) prepared on one surface of at least one of the second n-type electrode layer (67) and the second p-type electrode layer (44).

6. The laser diode of claim 5, wherein the second p-type compound semiconductor layer (40) includes:
a second p-type contact layer (46) disposed on the second p-type electrode layer (44) and formed of GaAs; and
a second p-type clad layer (48) disposed on the second p-type contact layer (46) and formed of AlGalnP,
wherein the second resonant layer (50) includes:
a second active layer (54) formed of AlGalnP; and
second waveguide layers (52a, 52b) disposed on and under the second active layer (54), respectively, and formed of AlGaInP,
and wherein the second n-type compound semiconductor layer (60) includes:
a second n-type clad layer (62) disposed on the second resonant layer (50) and formed of AlGaInP; and
a second n-type contact layer (64) disposed on the second n-type clad layer (62) and formed of AlGalnP.

7. The laser diode of any preceding claim, wherein the third laser diode (600) comprises:
a third laser oscillation layer including a third resonant layer (80) and a third n-type compound semiconductor layer (90) and a third p-type compound semiconductor layer (70) prepared on both surfaces of the third resonant layer, (80) respectively;
a third n-type electrode layer (98) and a third p-type electrode layer (74) prepared on both surfaces of the third laser oscillation layer, respectively; and
a bonding metal layer (72) prepared on one surface of at least one of the third n-type electrode layer (98) and the third p-type electrode layer (74).

8. The laser diode of claim 7, wherein the third p-type compound semiconductor layer (70) includes:
a third p-type contact layer (76) disposed on the third p-type electrode layer (74) and formed of GaAs; and
a third p-type clad layer (78) disposed on the third p-type contact layer (76) and formed of AlGaAs,
wherein the third resonant layer (80) includes:
a third active layer (84) formed of AlGaAs; and
third waveguide layers (82a, 82b) disposed on and under the third active layer (84), respectively, and formed of AlGaAs,
and wherein the third n-type compound semiconductor layer (90) includes:
a third n-type clad layer (92) disposed on the third resonant layer (80) and formed of AlGaAs;
a third buffer layer (94) disposed on the third n-type clad layer (92) and formed of GaAs; and
a GaAs substrate stacked on the third buffer layer (94).

9. A method of fabricating a multiple-wavelength laser diode, the method comprising:
preparing at least a first laser diode (200), a second laser diode (400), and a third laser diode (600), each having a first surface and a second surface that face each other;
bonding a second surface of the second laser diode (400) to a second surface of the first laser diode (200);
sequentially forming an electrode layer and a bonding metal layer (42) on a first surface of the second laser diode; and
bonding a second surface of the third laser diode (600) to the bonding metal layer (42) of the second laser diode (400),
wherein the first, second, and third laser diodes (200, 400, 600) are sequentially stacked and aligned such that centers of emission points (26, 56, 86) of the first, second, and third laser diodes form a line.

10. The method of claim 9, wherein a distance between two adjacent centers of the emission points of the first, second, and third laser diodes is less than 150 µm.

11. The method of claim 9 or 10, wherein the second laser diodes (400) further includes a substrate disposed on the first surface thereof,
the method further comprising removing the substrate of the second laser diode (400) after bonding the second surface of the second laser diode (400) to the second surface of the first laser diode (200) and before sequentially forming the electrode layer and the bonding metal layer on the first surface of the second laser diode (400).

12. The method of claim 9, 10, or 11, wherein the first laser diode (200) comprises:
a first laser oscillation layer including a first resonant layer (20) and a first n-type compound semiconductor layer (10) and a first p-type compound semiconductor layer (30) prepared on both surfaces of the first resonant layer (20), respectively;
a first n-type electrode layer (12) and a first p-type electrode layer (36) prepared on both surfaces of the first laser oscillation layer, respectively; and
a bonding metal layer (38) prepared on one surface of at least one of the first n-type electrode layer (12) and the first p-type electrode layer (36).

13. The method of claim 12, wherein the first n-type compound semiconductor layer (10) includes:
a GaN substrate (14);
a first buffer layer (16) disposed on the GaN substrate and formed of GaN; and
a first n-type clad layer (18) disposed on the first buffer layer (16) and formed of AlGaN,
wherein the first resonant layer (20) includes:
a first active layer (24) formed of InGaN; and
first waveguide layers (22a, 22b) disposed on and under the first active layer (24), respectively, and formed of InGaN,
and wherein the first p-type compound semiconductor layer (30) includes:
a first p-type clad layer (32) disposed on the first resonant layer and formed of AlGaN; and
a first p-type contact layer (34) disposed on the first p-type clad layer (32) and formed of GaN.

14. The method of any of claims 9 to 13, wherein the second laser diode (400) comprises:
a second laser oscillation layer including a second resonant layer (50) and a second n-type compound semiconductor layer (60) and a second p-type compound semiconductor layer (40) prepared on both surfaces of the second resonant layer (50), respectively;
an electrode layer prepared on a second surface of the second laser oscillation layer; and
a bonding metal layer (42) prepared on the electrode layer.

15. The method of claim 14, wherein the second n-type compound semiconductor layer (60) includes:
a GaAs substrate;
a second buffer layer disposed on the GaAs substrate and formed of GaAs;
a second n-type contact layer (64) disposed on the second buffer layer and formed of AlGalnP; and
a second n-type clad layer (62) disposed on the second n-type contact layer (64) and formed of AlGalnP,
wherein the second resonant layer (50) includes:
a second active layer (54) formed of AlGalnP; and
second waveguide layers (52a, 52b) disposed on and under the second active layer (54), respectively, and formed of AlGaInP,
and wherein the second p-type compound semiconductor layer (40) includes:
a second p-type clad layer (48) disposed on the second resonant layer (50) and formed of AlGalnP; and
a second p-type contact layer (46) disposed on the second p-type clad layer (48) and formed of GaAs,
the method further comprising removing the GaAs substrate and the second buffer layer after bonding the second surface of the second laser diode to the second surface of the first laser diode and before sequentially forming the electrode layer and the bonding metal layer on the first surface of the second laser diode (400).

16. The method of any of claims 9 to 15, wherein the third laser diode (600) comprises:
a third laser oscillation layer including a third resonant layer (80) and a third n-type compound semiconductor layer (90) and a third p-type compound semiconductor layer (70) prepared on both surfaces of the third resonant layer (80), respectively;
a third n-type electrode layer (98) and a third p-type electrode layer (74) prepared on both surfaces of the third laser oscillation layer, respectively; and
a bonding metal layer (72) prepared on one surface of at least one of the third n-type electrode layer and the third p-type electrode layer (74).

17. The method of claim 16, wherein the third n-type compound semiconductor layer (90) includes:
a GaAs substrate;
a third buffer layer (94) disposed on the GaAs substrate and formed of GaAs; and
a third n-type clad layer (92) disposed on the third buffer layer (94) and formed of AlGaAs,
wherein the third resonant layer (80) includes:
a third active layer (84) formed of AlGaAs; and
third waveguide layers (82a, 82b) disposed on and under the third active layer (84), respectively, and formed of AlGaAs,
and wherein the third p-type compound semiconductor layer (70) includes:
a third p-type clad layer (78) disposed on the third resonant layer (80) and formed of AlGaAs; and
a third p-type contact layer (76) disposed on the third p-type clad layer (78) and formed of GaAs.
